# EUROPEAN PATENT SPECIFICATION

(11) **EP 3 954 039 B1**
(45) Date of publication and mention of the grant of the patent: **10.04.2024**
(21) Application number: 20786953.8
(22) Date of filing: 10.04.2020
(51) Int. Cl.: H02S 10/40, H02S 30/10, H02S 40/36

(54) **SOLAR MODULE COMPRISING INTERCHANGEABLE SINGULATED STRIPS**
SOLARMODUL MIT AUSTAUSCHBAREN VEREINZELTEN STREIFEN
MODULE SOLAIRE COMPRENANT DES BANDES SÉPARÉES INTERCHANGEABLES

(30) Priority: 12.04.2019 US 201962833470 P
(43) Date of publication of application: 16.02.2022
(60) Divisional application: 24160561.7
(73) Proprietor: SolarCA LLC, San Ramon, CA 94583 (US)
(72) Inventor: GIBSON, Kevin, Fremont, CA 94538 (US); HAQUE, Nadeem, Fremont, CA 94538 (US); SHARMA, Suvi, Fremont, CA 94538 (US); CHANDRASHEKAR, Vishal, Fremont, CA 94538 (US)
(74) Representative: Herrero & Asociados, S.L.
(86) International application number: PCT/US2020/027741
(87) International publication number: WO 2020/210683

(56) References cited:
- US-A1- 2015 349 145
- US-A1- 2018 122 975

## Description

### BACKGROUND

Photovoltaic devices are becoming an increasingly important element of global energy production. As technologies for creating photovoltaic materials are improved and economies of scale manifest, the price of photovoltaic material has been dropping at an exponential rate, making photovoltaic installations increasingly cost-competitive with other energy production technologies.

Due to the high scalability of photovoltaic devices and the ubiquitous presence of solar radiation, photovoltaic energy generation is well suited for small-scale installations that serve individual residential and commercial structures. In these scenarios, photovoltaic cells are typically arranged into individual panels or modules, and one or more of the modules are installed in an area that is exposed to solar radiation. The modules convert solar energy to electricity, which is used to supply the energy needs of a structure, stored for future use, or delivered to the electrical grid.

As photovoltaic panels become more common, the appearance of the panels becomes increasingly important. Because photovoltaic panels are installed so that they are exposed to direct sunlight, they are often visible to the public, and are a prominent visual element of the structure on or near which they are installed.

Early versions of photovoltaic panels used uncut solar cells arranged side-by-side within a metal frame. The photovoltaic material used for the solar cells is typically a shade of blue, but due to variations in manufacturing, the blue tone can vary substantially from one cell to another, or even within the same cell. The cells were typically spaced apart from one another, and the space was often filled by a reflective metal material that connects adjacent cells. As a result, conventional photovoltaic panels have been a mosaic of different colors and have many visible reflective surfaces.

The aesthetic appearance of a photovoltaic panel is important for the adoption of photovoltaic energy generation. Many home and business owners are concerned about the appearance of their house or building and spend a considerable amount of time and money on the structure's appearance. However, it is difficult to integrate the mottled blue and metal colors of conventional photovoltaic panels into a pleasing aesthetic. In some cases, owners will forego purchasing and installing photovoltaic panels solely based on their appearance. Accordingly, photovoltaic panels with a pleasing aesthetic appearance open market sectors that were previously unavailable.

A key aesthetic consideration for photovoltaic panels is to have exterior surfaces that are all substantially the same color. In particular, panels that are monochromatic or have only minor variations in tone have a clean and desirable modern aesthetic appearance, especially compared to conventional panels with bright, blue and reflective metallic elements. Apart from monochromatic panels, a pleasing panel aesthetic can be created by reducing the variation in reflectivity of the visible panel components, and by controlling the color of panel elements to be visually compatible with structures on which the panels are installed. In addition to contributing to a poor appearance, reflective surfaces can distract or temporarily blind observers, creating a possible safety hazard.

Aesthetic considerations represent a barrier to adoption of solar energy. Some market segments that place a high value on aesthetics have declined to purchase photovoltaic panels due to the conventional panel aesthetic. For example, certain Home Owner's Association (HOA) rules prohibit photovoltaic panels from being installed within the HOA's jurisdiction because of the poor aesthetic qualities of conventional modules. From this perspective, being able to create an aesthetically pleasing photovoltaic panel will lead directly to the increased adoption of solar energy generation.

### SUMMARY

A solar module is fabricated by shingling multiple interchangeable strips. A semiconductor workpiece featuring micro-chamfers at its corners, bears a plurality of parallel thin conductive fingers extending between opposite edges. A first front side bus bar is formed overlapping the plurality of thin conductive fingers proximate to the first edge, with ends of the first bus bar not overlapping the micro-chamfers of the first edge. A second front side bus bar is formed overlapping the plurality of thin conductive fingers proximate to the second edge, with ends of the second bus bar not overlapping the micro-chamfers of the second edge. Additional front side bus bars are formed overlapping the plurality of thin conductive fingers at regular intervals in the interior of the workpiece, distal from the first edge and from the second edge. With the bus bars thus patterned, the workpiece is singulated into: •two edge strips featuring micro-chamfers and the respective first and second front side bus bars; and •interior strip(s) that each include one of the respective additional front side bus bars. A solar module comprising strings of strips, is assembled by interchangeably shingling the edge strips and the interior strips, where the first and second front side bus bars are overlapped and hidden by a previous, shingled element (e.g., another strip, a ribbon). Hiding the micro-chamfers and the first and second front side bus bars in this manner, ensures creation of a shingled solar module exhibiting a pleasing, homogenous visual appearance.

Document US2018122975A1 discloses a photovoltaic module with photovoltaic strips in a shingled configuration, where chamfers of a strip are hidden by the edge of another strip.

### BRIEF DESCRIPTION OF THE DRAWINGS

Figure 1A illustrates a perspective view of a front side of a photovoltaic workpiece prior to separation into strips.
Figure 1B illustrates a perspective view of a front side of a photovoltaic workpiece that has been separated into strips.
Figures 1C-1E illustrate side views of the separation and shingling of strips in order to assemble a string therefrom.
Figure 2A is an enlarged perspective view illustrating the overlapping shingled structure of a solar module according to an embodiment.
Figure 2B is an enlarged perspective view illustrating the overlapping shingled structure of a solar module according to an embodiment.
Figure 2C is an enlarged corner view showing a non-tapered bus bar.
Figure 2D is an enlarged corner view showing a tapered bus bar.
Figures 3A, 3B and 3C illustrate respective front, side and back surfaces of a photovoltaic string.
Figure 4 illustrates overlapped photovoltaic strips in a string.
Figure 5 is a simplified illustration of a photovoltaic module with three zones.
Figure 6 illustrates an assembled photovoltaic module.
Figures 7A-7K illustrate various views of a solar cell according to a specific example, prior to singulation into individual strips.
Figures 8A-8J illustrate various views of strips according to the specific example, following singulation.
Figures 9A-9D illustrate various view of a solar module assembled from a plurality of singulated strips according to the specific example.
Figure 10 is a simplified diagram summarizing a process flow according to an embodiment.
Figure 11 is an exploded view of a photovoltaic module.
Figure 12 is a back view of a photovoltaic module without the backsheet.
Figure 13 illustrates a conductive ribbon folded over an end of a string.
Figure 14 illustrates a conductive ribbon configuration.

### DETAILED DESCRIPTION

A detailed description of embodiments is provided below along with accompanying figures. The scope of this disclosure is limited only by the claims and encompasses numerous alternatives, modifications and equivalents. Although steps of various processes are presented in a particular order, embodiments are not necessarily limited to being performed in the listed order. In some embodiments, certain operations may be performed simultaneously, in an order other than the described order, or not performed at all.

Numerous specific details are set forth in the following description. These details are provided in order to promote a thorough understanding the scope of this disclosure by way of specific examples, and embodiments may be practiced according to the claims without some or all of these specific details. Accordingly, the specific embodiments of this disclosure are illustrative, and are not intended to be exclusive or limiting. For the purpose of clarity, technical material that is known in the technical fields related to this disclosure has not been described in detail so that the disclosure is not unnecessarily obscured.

It is convenient to recognize that a photovoltaic module has a side that faces the sun when the module is in use, and an opposite side that faces away from the sun. Although, the module can exist in any orientation, it is convenient to refer to an orientation where "upper," "top," "front" and "aperture side" refer to the sun-facing side and "lower," "bottom" and "back" refer to the opposite side. Thus, an element that is said to overlie another element will be closer to the "upper" side than the element it overlies.

Solar cells, also called photovoltaic (PV) cells, convert the sun's energy into electricity using semiconductors typically made of silicon. The cells are electrically connected to each other and assembled into a solar module. Multiple modules can be wired together to form an array. The larger and more efficient the module or array, the more electricity it can produce. Innovation is critical to optimizing solar module energy and reducing costs.

Embodiments of the present disclosure include high density strings of interconnected PV cells which are packed more efficiently onto the solar module to reduce inactive space between cells. Embodiments use advanced semiconductor manufacturing processes and equipment in which solar cells are scribed (cut) and singulated (separated) into highly-uniform strips, reassembled into strings of cells, packaged and tested.

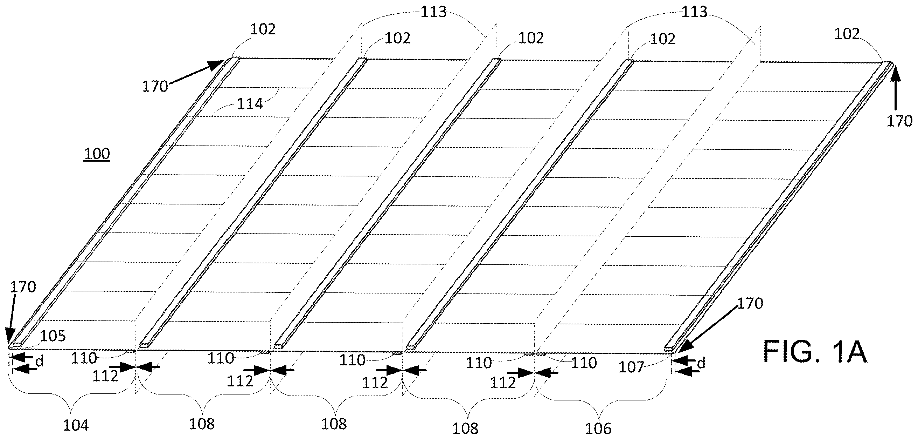

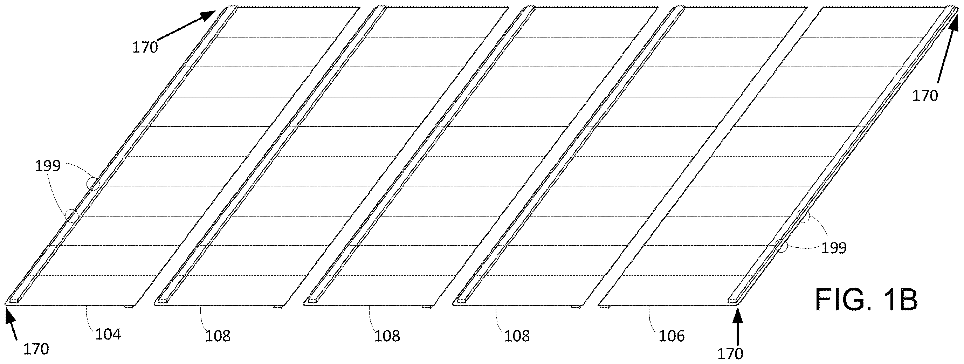

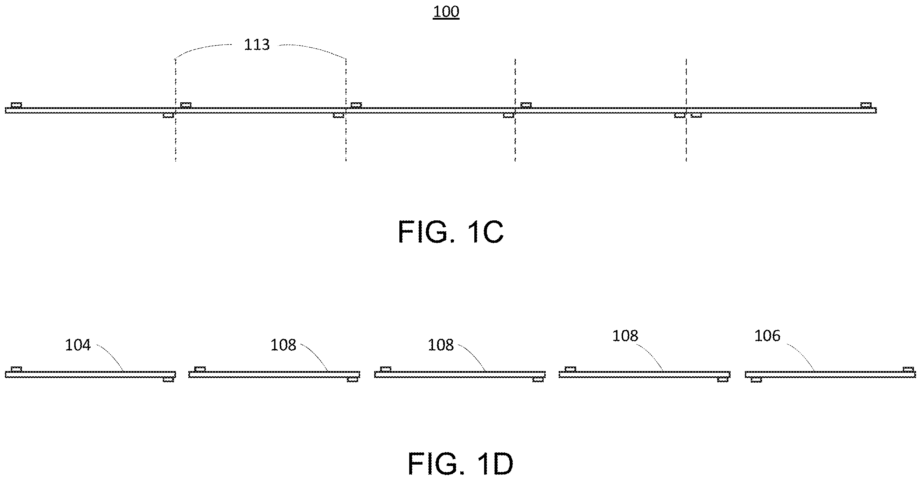

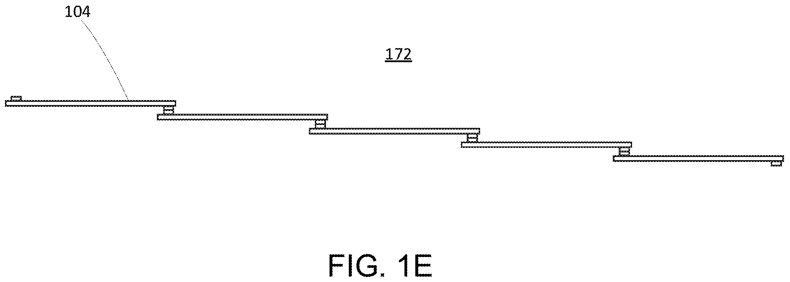

FIG. 1A is a front perspective view of a photovoltaic (PV) cell 100. This figure is merely an example of a photovoltaic cell, and one of ordinary skill in the art would recognize other variations, modifications, and alternatives to the specific embodiment shown in FIG. 1.

The surface of PV cell 100 illustrated in FIG. 1 is an aperture region of the cell 100 that exposes photovoltaic material, which is exposed to solar radiation. In various embodiments of PV cells 100, the photovoltaic material can be silicon, polycrystalline silicon, single crystalline silicon, or other photovoltaic materials as known in the art.

In some embodiments, the cell 100 is a rectangular cell with small chamfers 170 present at each corner. For ease of reference, these small chamfers are hereby also referred to as µ-chamfers.

These µ-chamfers may be characterized by a dimension of about 0.5 mm. In some embodiments the µ-chamfer may comprise segments of a circular arc characterized by a radius.

In a least this manner, the small chamfers of the instant disclosure can be differentiated from much larger workpiece chamfers characteristic of the formation of workpieces from circular substrates. Those larger chamfers may be linear in shape. Moreover, where those larger chamfers take the form of a circular arc segment, the radius of that circular arc is typically much longer, e.g., typically about half the width of the entire workpiece.

The solar cell 100 can be characterized as comprising a plurality of strips, each of which has a bus bar 102 on its front face.

The cell 100 has a first end strip 104 at a first edge of the cell, and a second end strip 106 at a second edge of the cell opposing to the first edge. The first end strip 104 includes a first front side bus bar 102 inset from the wafer edge by a distance d to define gap 105. The second end strip 106 includes a second front side bus bar 107 inset from the wafer edge by the distance d to define gap 105.

The particular simplified example of the wafer of FIG. 1A, features nine (9) thin conductive fingers 114 that are arranged perpendicular to the bus bars 102, and visible on the aperture surface of the strips. However, embodiments are not limited to any particular number of thin conductive fingers.

As described in detail herein, the thin conductive fingers do not extend all of the way to the edge of the wafer. Hence gaps 105 may or may not include portions of the thin conductive fingers. Furthermore, the end strips also include the µ-chamfer feature. One or both of these features (gap, µ-chamfer) may result in the end strips having visual appearance differing from other strips formed from the interior of the wafer, as is now described.

In particular, three rectangular interior strips 108 are disposed in a central, interior portion of the PV cell 100. Each of the interior strips 108 in FIG. 1 has a rectangular shape (lacking µ-chamfers), and a bus bar 102 running across the front surface. Unlike the end strips just described, the thin conductive fingers run end-to-end across the entire width of the strip. One or both of these features cause the interior strips to different in physical appearance from the end strips.

On back faces of the strips, every strip has one backside bus bar 110 at its opposite edge. The backside bus 110 associated with the second end strip 106 is separated from the backside bus bar 110 associated with the adjacent interior strip 108 by a narrow scribe region 112, indicated here with a perpendicular separation plane 113. The scribe region 112 is a region where the cell may be cut to separate the various strips.

In the cell 100 of FIG. 1A, the first end strip 104, the second end strip 106, and the plurality of interior strips 108 are arranged in parallel to each other in the cell 100 such that the cell is divided into a total of five strips including two interior strips 108. However, no particular number of interior strips is required.

In an embodiment, the PV cell 100 has a length and a width of 156.75 mm plus or minus 2 mm, but other embodiments are possible.

According to embodiments, the solar cell 100 is subjected to a separation or singulation process in which the strips are physically separated from one another using, for example, mechanical sawing or laser energy. The strips may be separated from one another by dividing the PV cell 100 at the separation planes indicated, so that each face of a strip has a bus bar located at an edge of the strip.

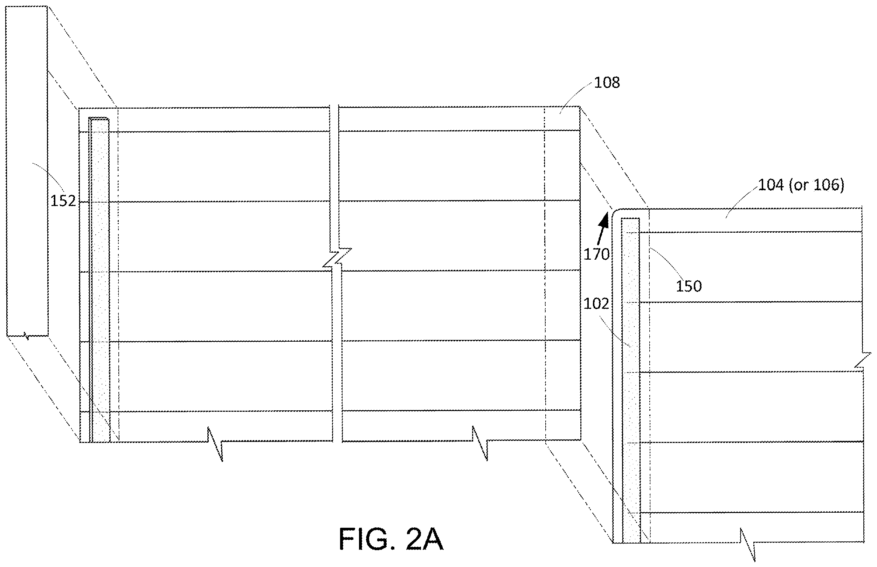

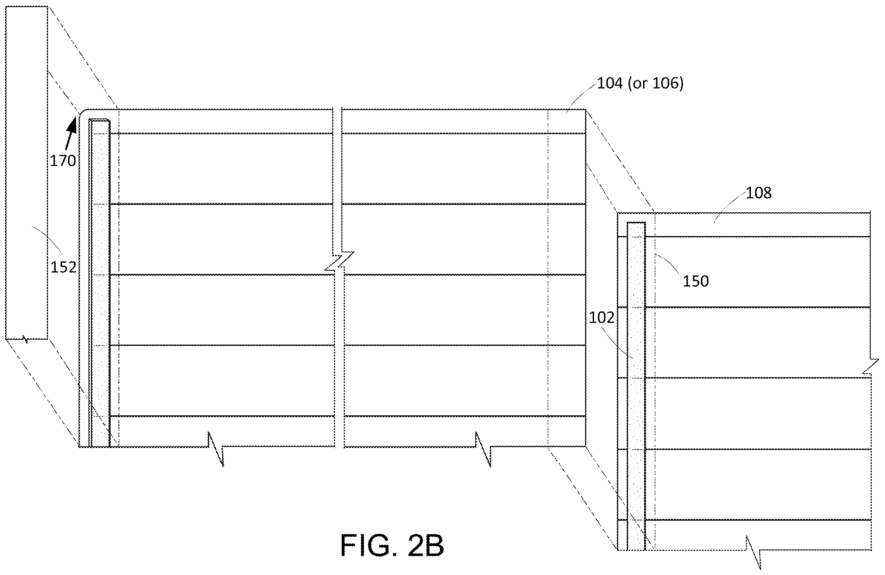

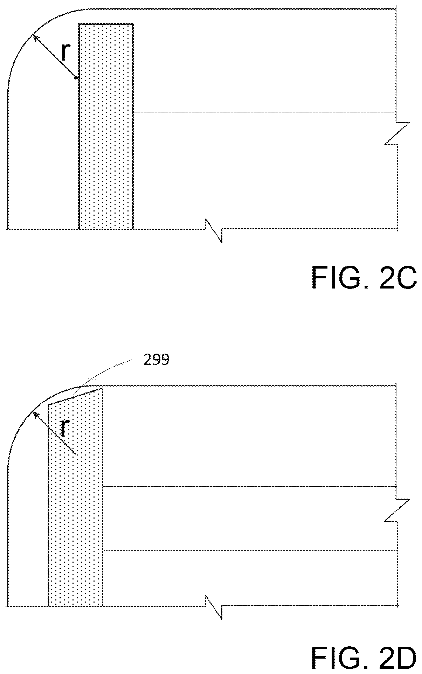

FIG. 1B is a front perspective view of a PV cell 100 that has been subjected to a separation process that separates the cell into a plurality of individual strips. In the embodiment shown in FIG. 2, the cell 100 is separated into first and second end strips 104 and 106, as well as three rectangular strips 108 from the middle of the cell.

From FIG. 1B, it is apparent that each strip has one bus bar exposed on each face of the strip. The front face of first end strip 104 exposes a first front bus bar 102, the front face of second end strip 106 shows a second front bus bar 102, and each of the front faces of the strips 108 from the interior of the cell have a corresponding front bus bar 102 present on one edge.

By locating the front bus bar over the substrate edge, the ends of the substrate, the µ-chamfers, and the small areas of gaps 199 in which the thin conductive fingers stop short of the substrate edge, are effectively hidden. Accordingly, the first and second end strips 104 and 106 have substantially the same visual appearance as each of the interior strips 108.

That is, the end and interior strips have a very similar visual appearance and can be interchangeably used in assembling a solar module through shingling as is described in detail below. No special handling of end strips versus interior strips is required in order to achieve a solar module exhibiting a homogenous, pleasing visual appearance.

Figures 1C-1E illustrate side views of the separation and shingling of strips in order to assemble a string therefrom. In this particular embodiment, an end strip 104 is used as the first shingle in the assembled string.

Figure 2A is an enlarged view illustrating the overlapping shingled structure of a solar module according to an embodiment. In this particular embodiment, the first shingled element is an interior strip 108, which overlaps with footprint 150 a subsequent end strip (104 or 106) element. In this manner, both the µ-chamfers and the gap of the end strip are hidden from view. A ribbon 152 overlaps the front side bus bar of the initial shingle (the interior strip) of the string.

Figure 2B is an enlarged view illustrating the overlapping shingled structure of a solar module according to an alternative embodiment. Here, the first shingled element is an end strip (104 or 106), which overlaps with footprint 150 a subsequent interior strip element 108. In this manner, the gap of the interior strip is hidden. A ribbon 152 overlaps the front side bus bar of the initial shingle (the end strip) of the string, thereby hiding both the µ-chamfers and the gap.

Figure 2C shows an enlarged corner view of a solar cell according to an embodiment. As previously described, the corner exhibits a µ-chamfer exhibiting a curved profile corresponding to a segment of a circular arc having radius r.

While Figure 2C shows the bus bar as having non-tapered ends, this is not required.

Figure 2D shows an enlarged corner view of an alternative embodiment having a bus bar with tapered end(s) 299. Such a tapered configuration may allow locating the bus bar closer to the µ-chamfer, thereby freeing up additional surface area of the solar cell to be occupied by photosensitive material and increasing collection efficiency.

Returning to Figures 1A-B, although these illustrate strips separated from a standard sized cell 100, other embodiments are possible. For example, it is possible to cut PV strips from cells of a variety of shapes and sizes.

As just described, the presence of a front bus bar 102 and back bus bar 110 facilitates a tiled arrangement of individual strips into a string. Further discussion regarding the assembly of singulated strips into strings, and assembly of strings into a larger solar module, is now provided.

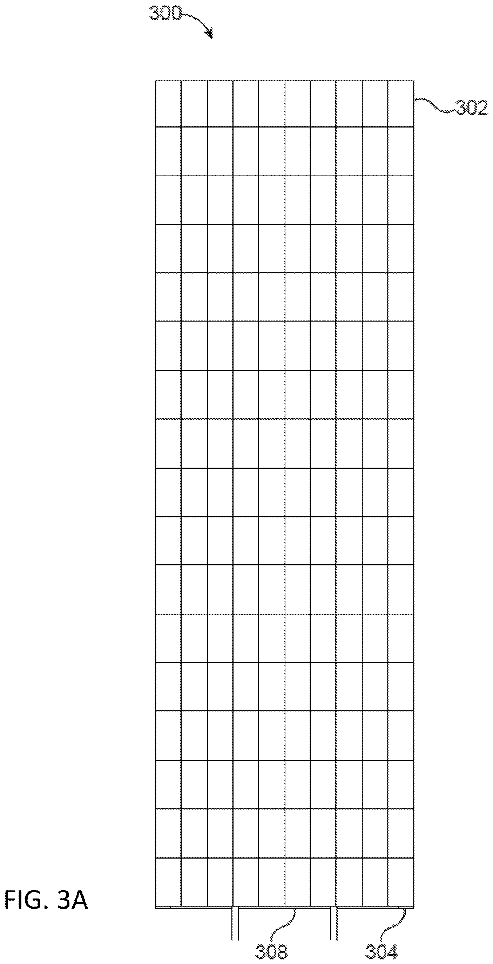

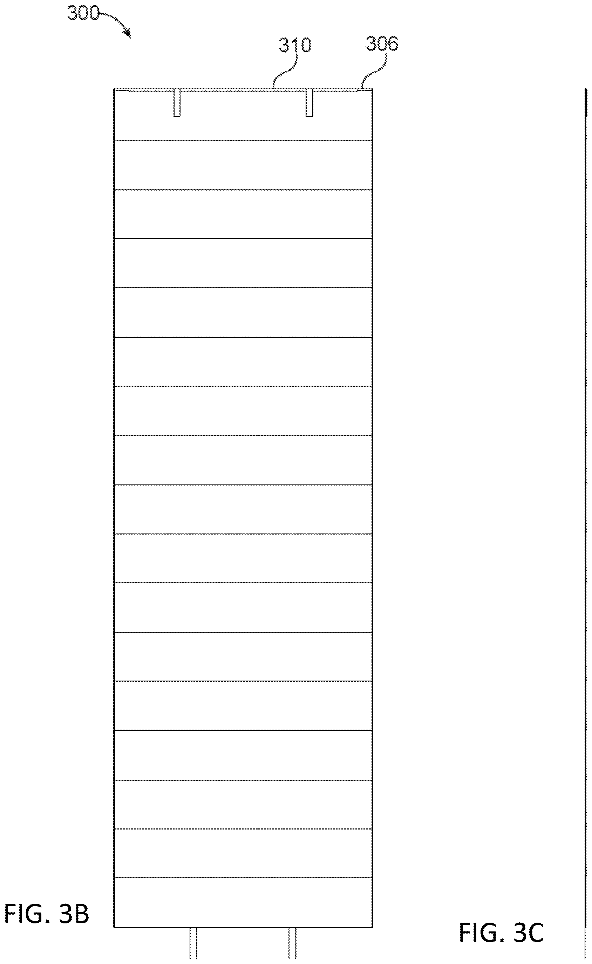

FIGS. 3A, 3B and 3C illustrate an embodiment of a string 300 that comprises a plurality of strips 302, each connected on a long edge to at least one other strip. FIG. 3A shows a front face of a string 300, FIG. 3B shows a back face of the string 300, and FIG. 3C shows a side view of the string 300.

In the embodiment of FIGS. 3A to 3C, the string 300 has seventeen (17) strips 302 coupled in series. However, the number of strips 302 in a string 300 can vary between different embodiments. For example, a string 300 may comprise two strips 302, ten strips 302, twenty strips 302, or fifty strips 302.

The number of strips 302 in a string 300 affects the electrical characteristics of the string. When strips 302 are connected in series to form a string 300, the current of an individual strip is the same as the current for the entire string, but the voltage of each strip is combined. In a simplified example, a string of 10 strips, in which each strip operates at 5 volts and 5 amps, would have an operating voltage of 50 volts and an operating current of 5 amps. Thus, arranging strips 302 into strings 300 facilitates adapting electrical characteristics of photovoltaic material.

As seen in FIG. 3C, strips 302 are arranged in an overlapped or tiled configuration within a string 300. In more detail, front bus bars 304 of strips 302 in the string 300 overlap with and are electrically and mechanically coupled to back bus bars 306 of adjacent strips. In embodiments, the strips 302 may be connected by a material such as a metallic solder or an electrically conductive adhesive (ECA).

An ECA has several advantages as a coupling material in a string 300. Polymeric components of ECA can provide higher elasticity than metal materials, which can help maintain a mechanical bond under various thermal states when the materials contract and expand. In other words, the ECA can relieve mechanical stress caused a coefficient of thermal expansion (CTE) mismatch between mated materials. ECA can be formulated to be soluble to various solvents, which facilitates various manufacturing processes. In addition, an ECA bond is typically more elastic than, for example, a solder bond, so an ECA bond is less prone to cracking during assembly.

In an embodiment in which strips are connected by ECA, the ECA may be a cured adhesive polymer formulation that is highly loaded with conductive metal particles. In some embodiments, the conductive metal is silver. The ECA may be a thermosetting acrylate adhesive. The adhesive may have may be modified with one or more hardening components such as epoxy, phenol-formaldehyde, urea-formaldehyde, etc., that provide hardness and bonding strength. In an example, the ECA is a low temperature cure one-part adhesive.

When strips 302 are connected in series in a string 300, bus bars at the far ends of the string are exposed. In other words, unlike strips 302 in the middle of a string 300, one bus bar of the outermost strips in a string is connected to an adjacent strip, but one bus is not connected to a strip. Instead, in embodiments of the present disclosure, bus bars of the outermost strips 302 are connected to conductive ribbons.

In embodiments of the present disclosure, a system utilizes a 1/5th strip width versus 1/3rd, 1/4th or 1/6th of a cell strip width, as shown in Table 1 below.

**[Table 1]**

| | PV Width | | | | | Comment |
|---|---|---|---|---|---|---|
| Width | 78 | 52 | 39 | 31.2 | 26 | mm |
| Cell Current | 4.5 | 3 | 2.25 | 1.8 | 1.5 | I_{SC} = 9A standard cell |
| Fingers | 80-200 | 80-150 | 80-120 | 80-100 | 80 | (Microns) Based on standard cell finger |
| Shading | 7.0% | 5.8% | 5.0% | 4.5% | 4% | Finger shading |
| Cell Utilization | 98.7% | 97.4% | 96.2% | 94.9% | 93.6% | 2mm overlap |
| Placements | 2X | 3x | 4X | 5X | 6X | Over standard module |
| Fill Factor | 76% | 77% | 78% | 79% | 79% | |

In Table 1, width refers to the width of a strip after it has been cut from a cell. Current is the amount of current that a strip produces, which is directly proportional to the size of the strip. Fingers carry current across a strip, while shading is the area of the strip shadowed by the fingers. Cell utilization is the amount of area in a string in which strips do not overlap one another. The number of placements is how many strips are cut from a cell and placed in a string. Fill factor is the efficiency of the photovoltaic material present in a string compared to its maximum power producing potential.

In an example, modules are configured to have current and resistance characteristics that are similar to a conventional module (Voc, Vmp, Isc, Imp, Power). However, modules can be designed to have different characteristics for different applications. For example, modules created according to embodiments of this disclosure can be configured to have lower voltage and higher current for the solar tracking applications, and to have higher voltage and lower current for residential modules that interface with module power electronics.

In an example, one embodiment uses a 31.2 mm strip width, which optimizes module characteristics, as well as providing a current and voltage similar to standard modules. This allows embodiments to take advantage of standard inverters, electronics, and mechanical features.

It is emphasized that embodiments are not limited to strips of photovoltaic material having any particular dimensions. For example, the following Table 2 summarizes the dimensions of some possible strips that may be utilized according to various examples.

**[Table 2]**

| **Strip width (mm)** | **Dimension of Square Substrate (mm)** | **Placements** |
|---|---|---|
| 31.75 | 158.75 | 5X |
| 26.46 | 158.75 | 6X |
| 32.3 | 161.7 | 5X |
| 26.9 | 161.7 | 6X |
| 33.2 | 166 | 5X |
| 27.6 | 166 | 6X |
| 42 | 210 | 5X |
| 35 | 210 | 6X |
| 44 | 220 | 5X |
| 36.6 | 220 | 6X |

Embodiments may comprise strips formed by singulation of substrates having dimensions of a range of between about 156 - 220 mm. Individual strips may have a width of a range of between about 26-78 mm. In some embodiments, individual strips may have a width of a range of between about 26-44 mm.

FIG. 3A shows a front ribbon 308 over the exposed front bus bar 304 of the lowermost strip 302 in the string 300. As seen in FIG. 3B, a back conductive ribbon 310 covers the back bus bar 306 at of the uppermost strip 302 of the string 300. The back bus bar 306 is the back terminal of a strip 302, and front bus bar 304 is a front terminal. Each of the front and back ribbons 308 and 310 has two tabs protruding from the respective the ribbon. In a flat orientation, the tabs of the front ribbon 308 extend outward from the string 300, while the tabs of back ribbon 310 extend inwards from the edge strip to which the back ribbon 310 is attached towards the middle of the string. In an embodiment, the front surface of a strip 302 has a positive polarity and the back surface has a negative polarity. However, other embodiments are possible, where the exposed front aperture surfaces has negative polarity and the back surface has positive polarity.

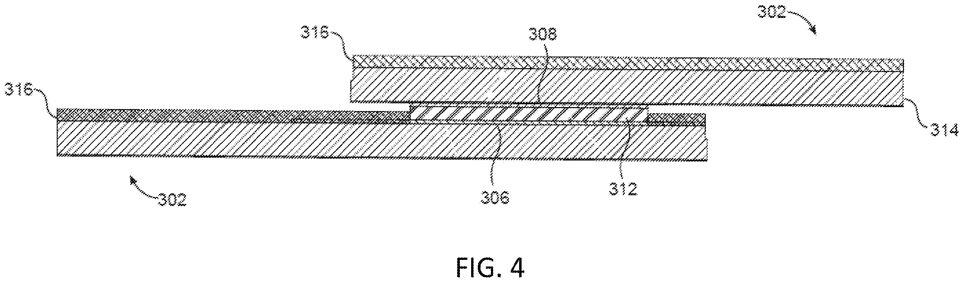

FIG. 4 shows a detail view of an overlapped joint in which two adjacent strips 302 are connected to one another in a string 300. The overlapped open ends of the strips 302 have a staggered profile, which results from a separation process in which PV cells are separated using two distinct operations, e.g. a scribe operation and a breaking operation. A cutting operation may result in a kerf in the inset portion of the edge, while a breaking operation does not cause a kerf, resulting in the slight protrusion visible in FIG. 4.

Each strip 302 in the string 300 has a thickness of PV material 314 and a thickness of a backing material 316. In many conventional PV cells, the backing material 316 is aluminum, but embodiments are not limited to that material. A back bus bar 306 is exposed by the backing material 316, and a layer of ECA 312 mechanically and electrically couples the back bus bar 306 to a front bus bar 308 on the overlapped strip 302.

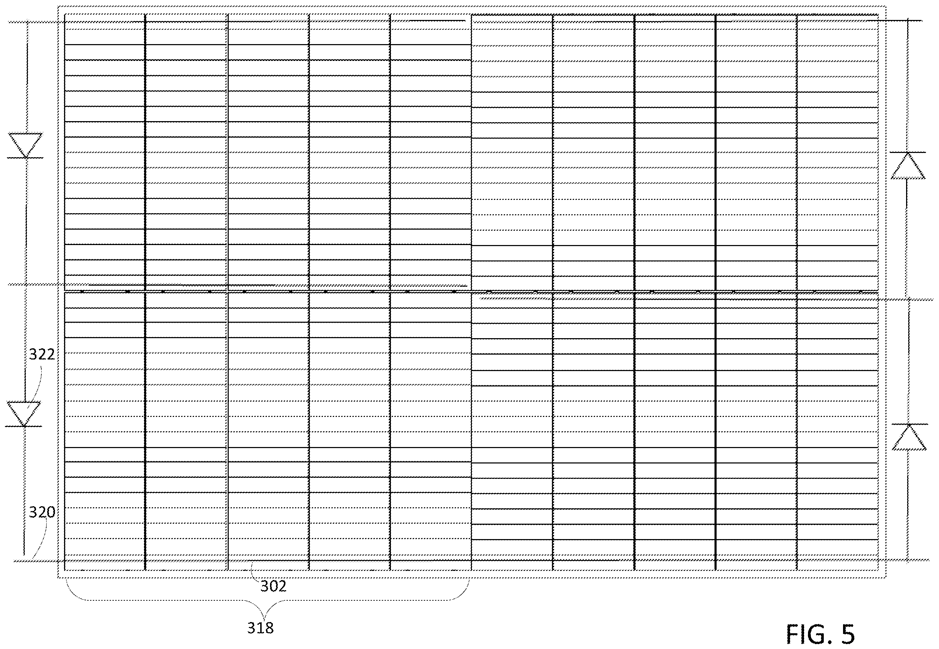

FIG. 5 is a simplified diagram of a photovoltaic apparatus that comprises a plurality of strings 300 that are arranged into a plurality of zones 318. In the specific embodiment shown by FIG. 5, each string 300 has 20 strips 302 connected in series with one another. Each string 300 is connected in parallel with five additional strings through electrical busses 320 disposed at opposing ends of the parallel connected strings, so that a total of six strings are connected in parallel. Each set of strings 300 that are connected in parallel is referred to herein as a "zone" 318.

The number of strings 300 in a zone 318 may vary between embodiments. For example, other embodiments may have from two to ten strings 300 in a zone 318. In addition, the number of zones 318 in a module can vary between embodiments.

The embodiment shown in FIG. 5 has four separate zones 318, and each zone is protected by a single diode 322 coupled in parallel to the five strings 300 in the respective zone. Conventional PV module arrangements are divided into multiple cells that are all connected in series with one another, and diodes are periodically disposed between sub-groups of the series connected cells. In such conventional arrangements, when a single cell is disabled, for example by being shaded, all other cells coupled to the same diode are also disabled. In other words, in conventional devices, when one cell is disabled, all cells that are coupled to the diode that protects the disabled cell are also disabled.

In contrast, the PV device shown in FIG. 5 has better performance. Each diode 322 protects a zone 318 in a much more efficient manner than conventional devices. Like conventional devices, when one or more strip 302 in a first string 300 is disabled, all of the strips in the first string are disabled, and current flows through the diode 322. However, unlike conventional devices, all other strings 300 that are present in the same zone 318 and do not have any disabled strips 302 continue to produce normal levels of energy. Accordingly, energy losses due to shading are much lower in embodiments of the present application than conventional devices.

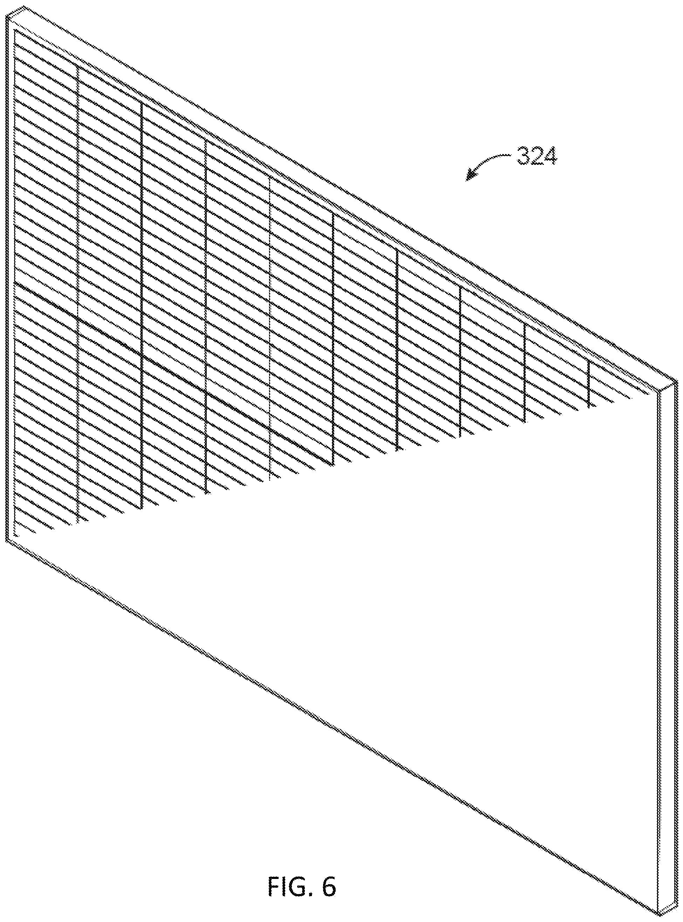

FIG. 6 shows an example of a PV module 324 that includes the photovoltaic components shown in FIG. 5. In more detail, the PV module 324 shown in FIG. 6 has 20 strings 300, and each string 300 has twenty (20) of strips 302 that are mechanically and electrically connected in series with one another.

Returning to FIGS. 3A and 3B, the front bus bar 304 of a string 300 is covered by a front ribbon 308, and the back bus bar 306 is covered by back ribbon 310. The ribbons are mechanically and electrically connected between the respective bus bars of the PV string 300 and electrical busses 320.

### EXAMPLE

Details regarding an embodiment according to a specific example, are now provided. This specific example describes a solar cell that is singulated into five strips, which are then assembled into strips of a solar module.

As a threshold matter, it is noted that while the µ-chamfer of the embodiment of Figures 1A-1B exhibits a rounded profile, this is not required. According to alternative embodiments, the µ-chamfer may be substantially linear in shape. This particular example relates to a solar cell and singulated strips, having such a µ-chamfer with a linear profile.

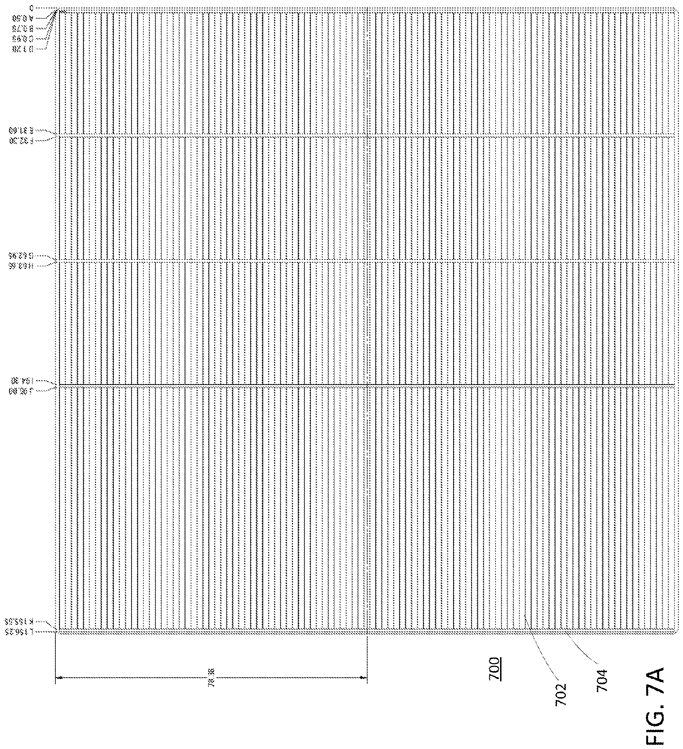

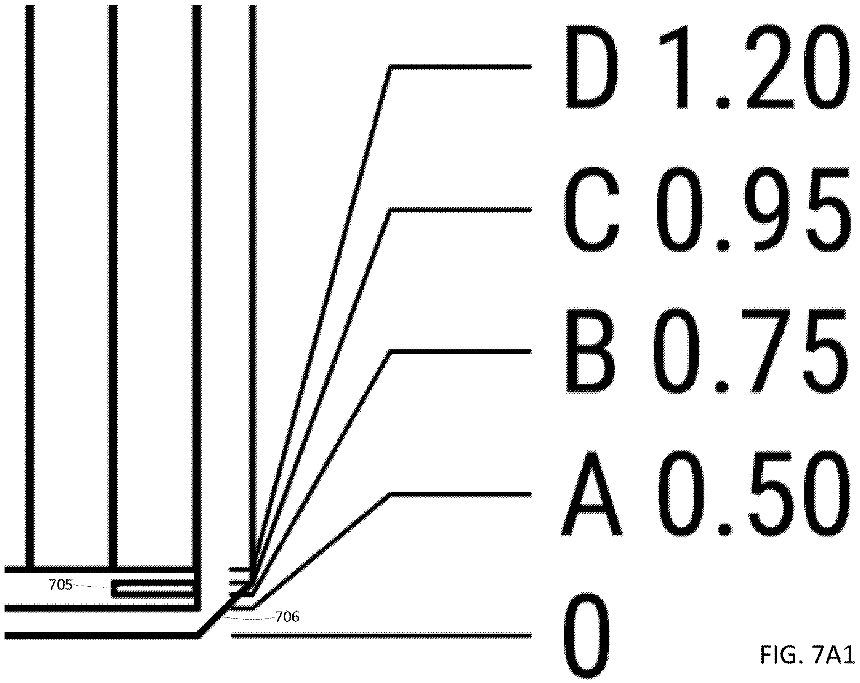

Figures 7A-9D depict various views according to the specific example. Unless otherwise indicated, dimensions are in mm.

Figures 7A-7K illustrate various views of a solar cell according to the example, prior to singulation into individual strips. In particular, Figure 7A is a plan view offering specific dimensions of the front side of the exemplary solar cell 700, bearing patterned fingers 702 and overlapping front side bus bars 704.

Figure 7A1 is an enlargement of a corner portion of the substrate front side prior to singulation. Figure 7A1 shows a cut-out 705 between fingers that may be used as a locating feature, and also shows the µ-chamfer 706.

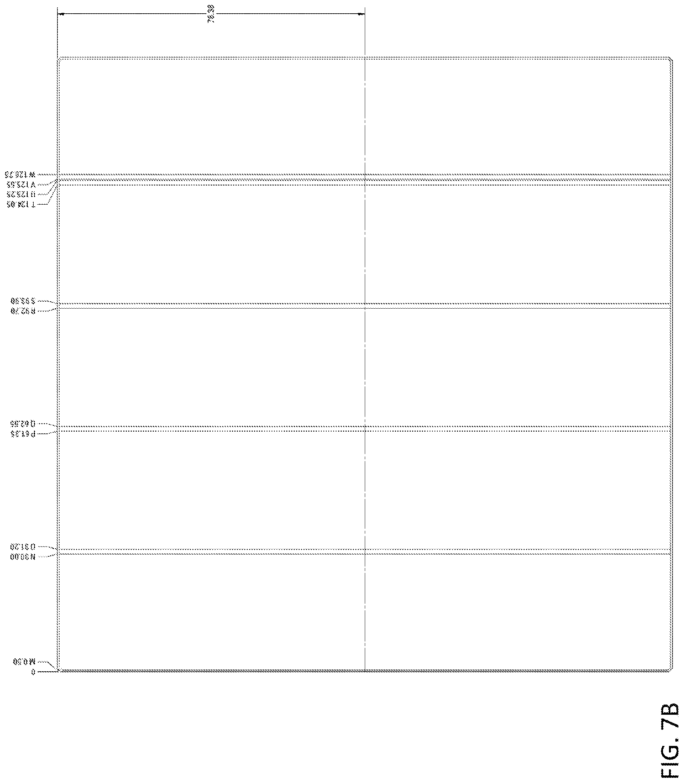

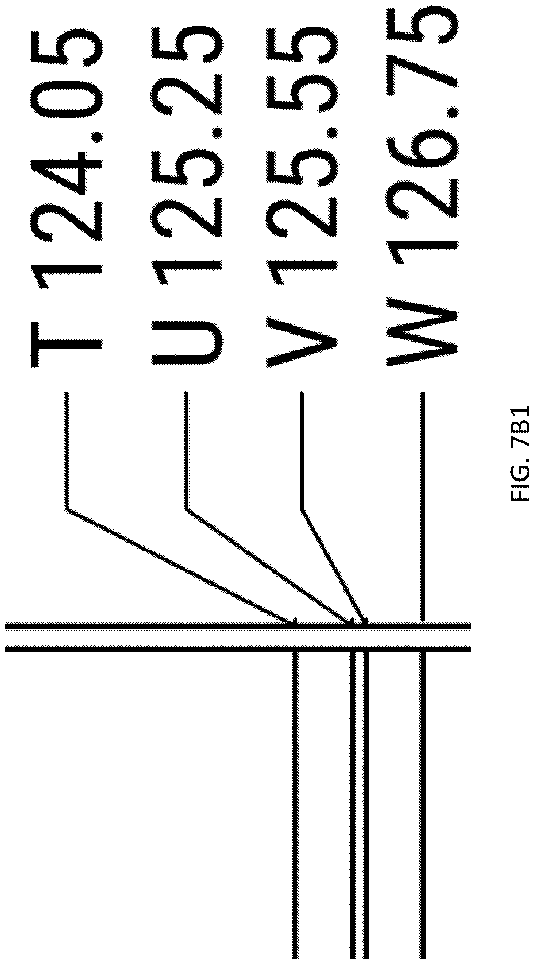

Figure 7B shows a corresponding plan view of the back side of the exemplary solar cell. Again specific dimensions are included, with Figure 7B 1 offering an enlarged view of a portion of the substrate back side proximate to an interior scribe line.

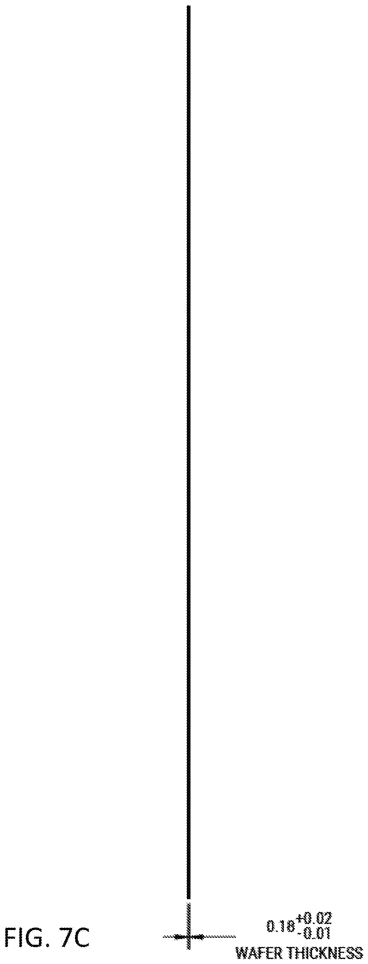

Figure 7C offers and end view illustrating the thickness of the exemplary solar cell.

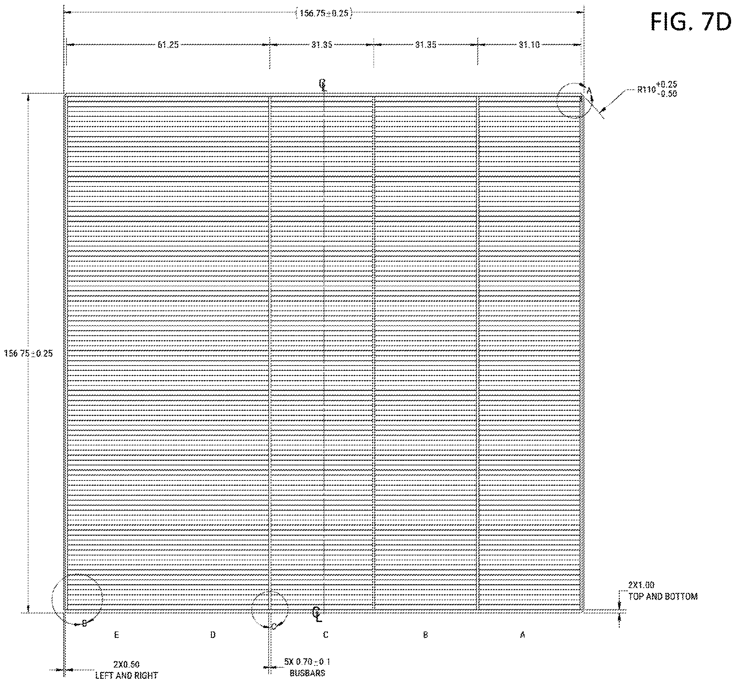

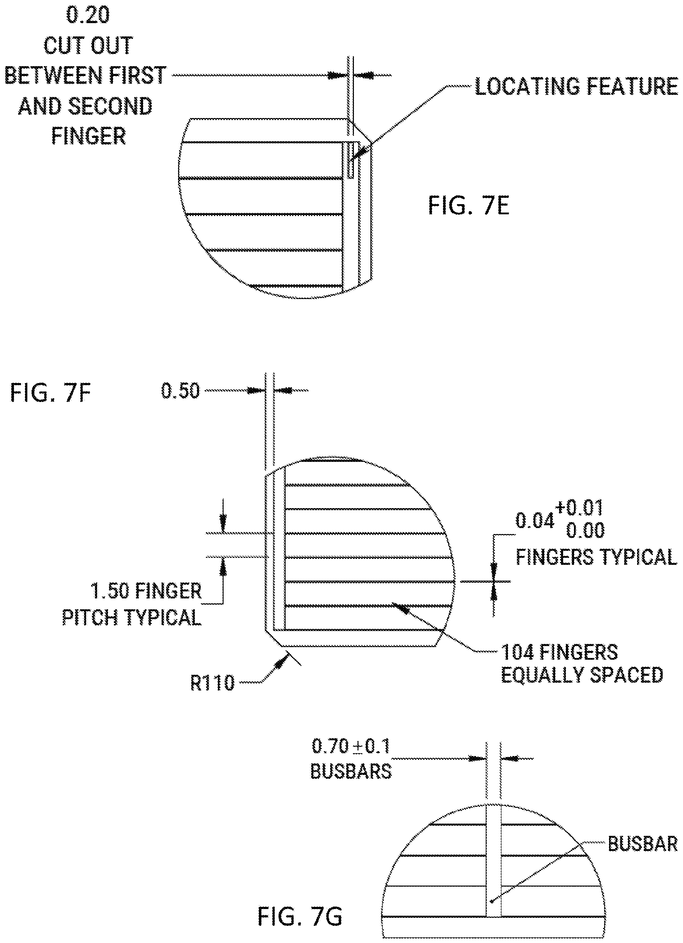

Figure 7D is an additional plan view of the front side of the exemplary solar cell. Figure 7E offers an enlarged view of corner detail A of Figure 7D. Figure 7F offers an enlarged view of the corner detail B of Figure 7D. Figure 7G offers an enlarged view of the interior detail C of Figure 7D.

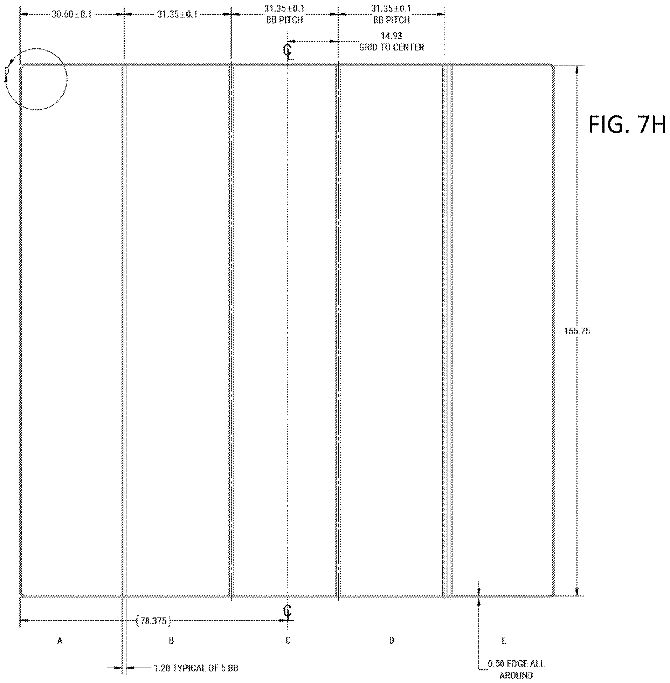

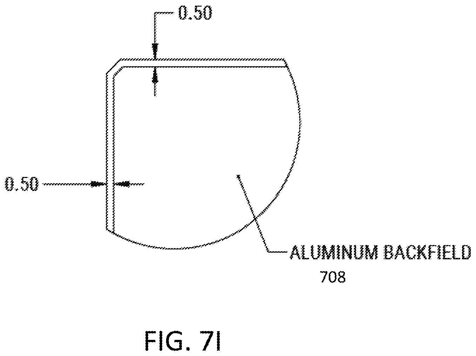

Figure 7H is an additional plan view of the back side of the exemplary solar cell. Figure 7I offers an enlarged view of the corner detail D of Figure 7H. This figure also shows the aluminum backfield 708, as well as the µ-chamfer.

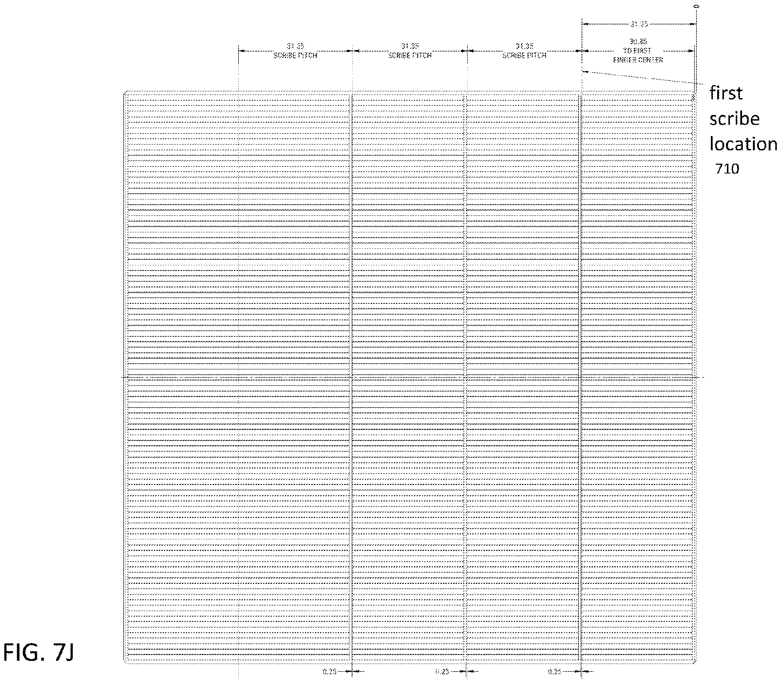

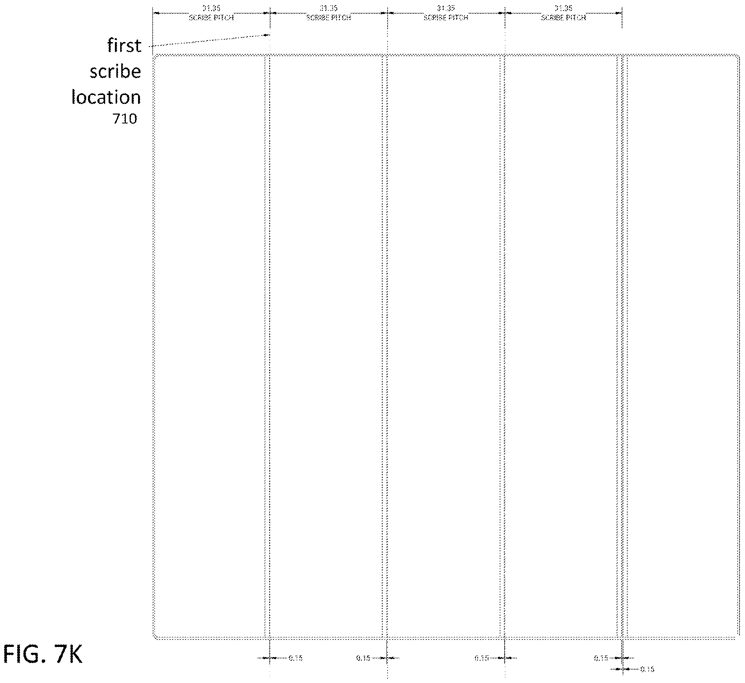

Figure 7J is an additional plan view of the front side of the exemplary solar cell showing scribe locations 710. Figure 7K is an additional plan view of the back side of the exemplary solar cell showing the scribe locations.

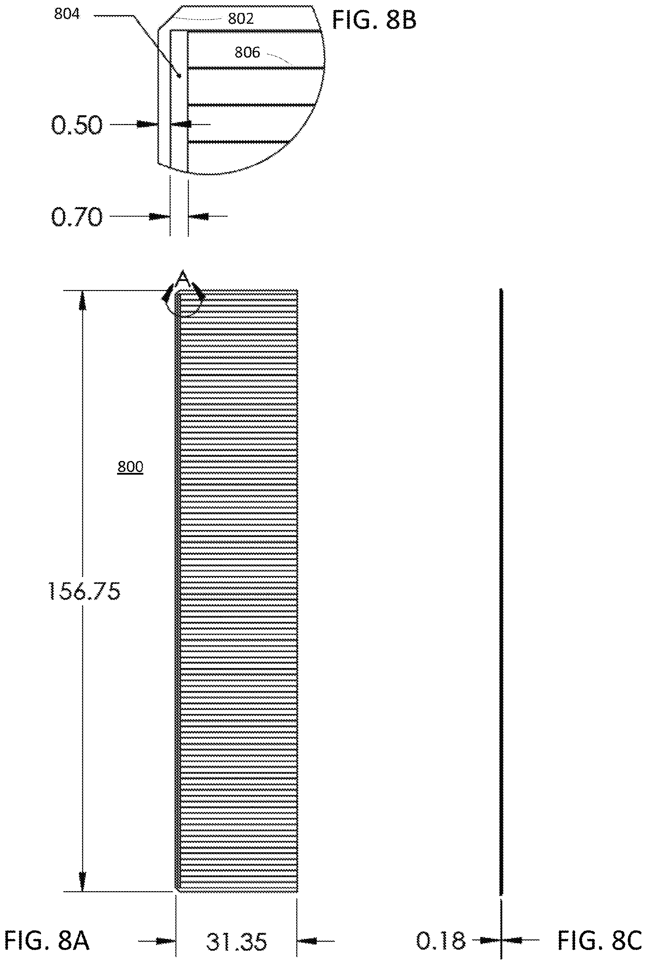

Figures 8A-8E illustrate various views of end strips according to the specific example, following singulation. In particular, Figure 8A shows a plan view of a front side of an exemplary end strip 800, including dimensions thereof.

Figure 8B depicts an enlarged view of detail A of the corner portion the Figure 8A. The strip µ-chamfer 802, bus bar 804, and conductive fingers 806 are clearly shown, together with dimensions.

Figure 8C offers an end view of the singulated end strip of Figure 8A, showing the thickness dimension thereof.

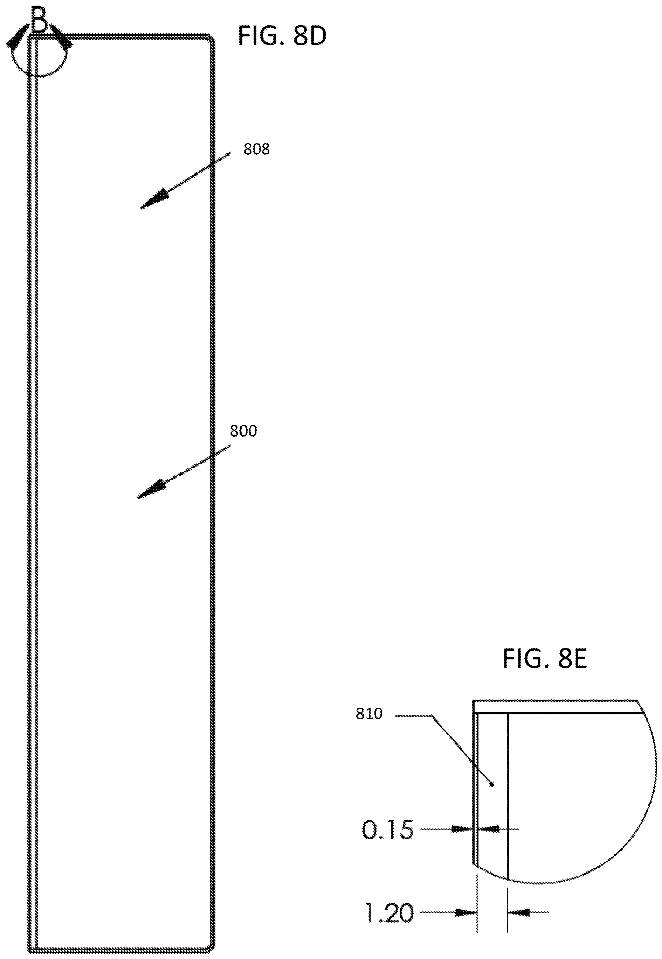

Figure 8D shows a plan view of a back side of the exemplary end strip, including dimensions thereof and an aluminum backfield 808. Figure 8E depicts an enlarged view of detail B of the corner portion the Figure 8D showing backside bus bar 810.

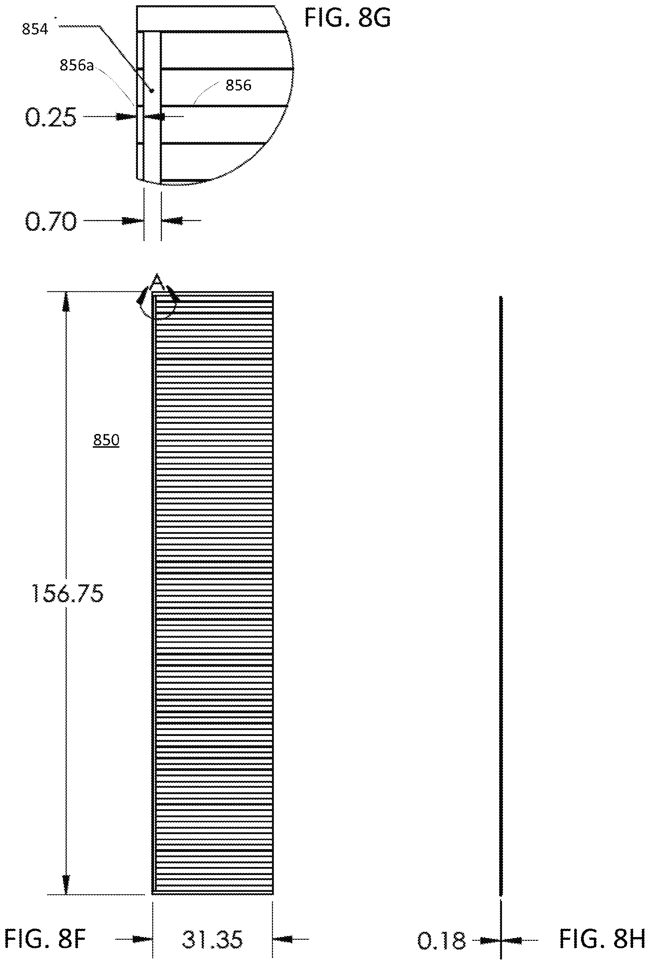

Figures 8F-8J illustrate various views of interior strips according to the specific example, following singulation. In particular, Figure 8F shows a plan view of a front side of an exemplary interior strip 850, including dimensions thereof.

Figure 8G depicts an enlarged view of detail A of the corner portion the Figure 8F. The strip frontside bus bar 854 and conductive fingers 856 are clearly shown, together with dimensions. It is noted that portion 856a of the conductive fingers extends past the bus bar.

Figure 8H offers an end view of the singulated interior strip of Figure 8G, showing the thickness dimension thereof.

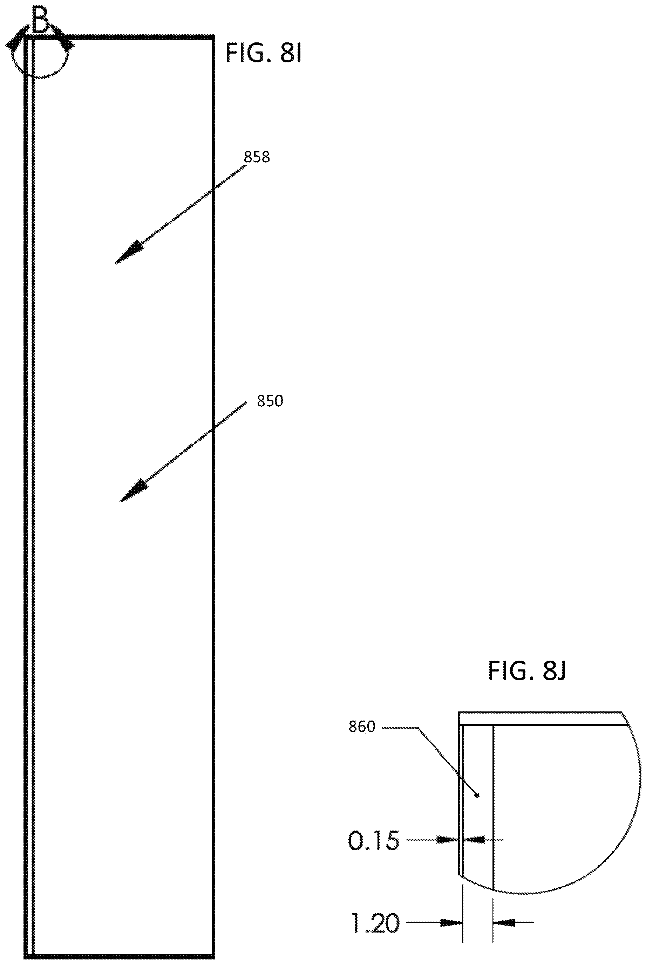

Figure 8I shows a plan view of a back side of the exemplary interior strip, including dimensions thereof and an aluminum backfield 858. Figure 8J depicts an enlarged view of detail B of the corner portion the Figure 8I, including back side bus bar 860.

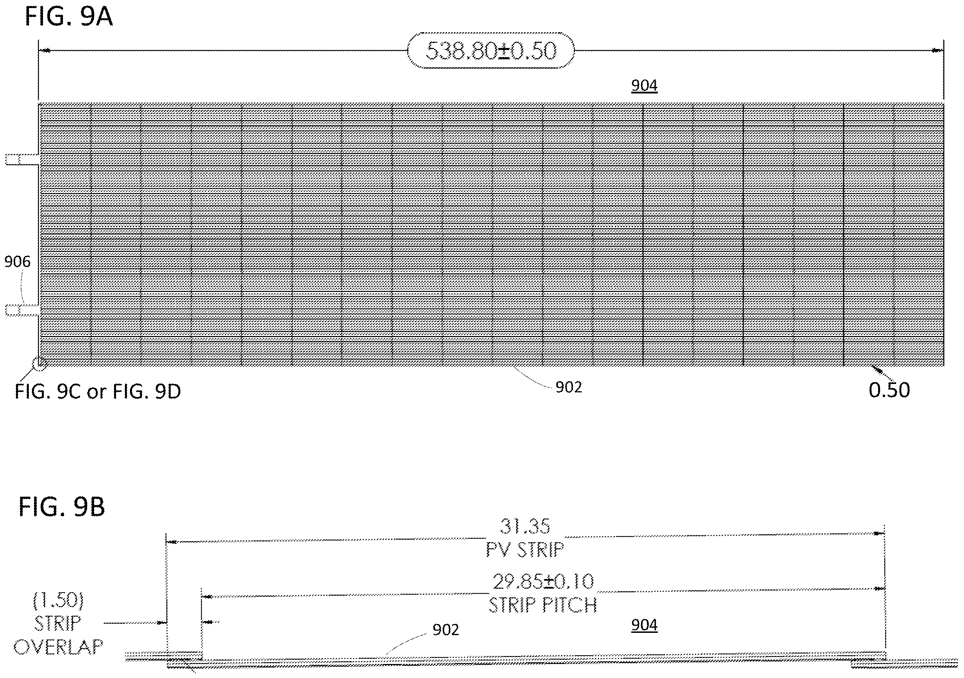

Figures 9A-9D illustrate various view of a solar module that is assembled from a plurality of singulated strips (both end and interior) according to the specific example. In particular, Figure 9A shows a plan view of the front side of the assembly of shingled strips 902 forming the string 904, including a front ribbon 906.

Figure 9B shows an enlarged cross-section in an interior of the assembled string. This view clearly shows a singulated strip 902 as being overlapped by an upstream strip of the sting, and overlapping a downstream strip of the string, in a shingled manner.

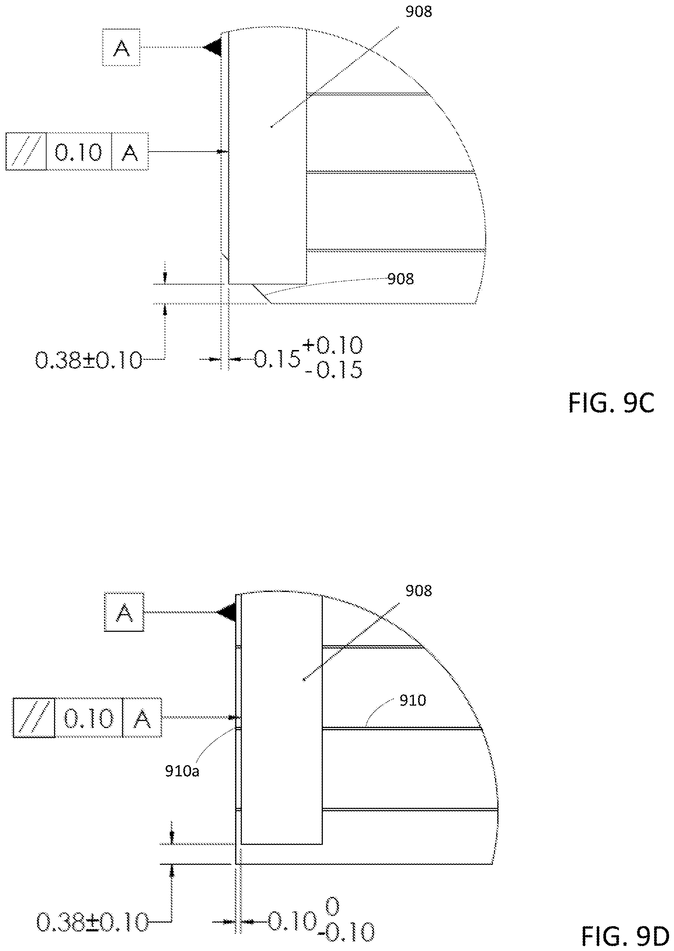

Figures 9C and 9D show enlarged corner views of the string of Figure 9A. Figure 9C shows where the first strip in the string, comprises a singulated end strip. Here, the front ribbon 906 entirely overlaps the front side bus bar, hiding it from view.

It is noted that the front ribbon in Figure 9C only partially overlies the µ-chamfer 908. According to this shingled configuration, however, any µ-chamfers of other singulated end strips included as part of the string, would be obscured by the overlapping edge of the upstream strip, thereby rendering them nearly visually indistinguishable from the other strips (including interior strips) making up the string.

Figure 9D shows an alternative embodiment where the first strip in the string, comprises a singulated interior strip. Again, the front ribbon 906 entirely overlaps the front side bus bar, hiding it from view.

It is noted that short end portions 910a of the conductive fingers 910, are not entirely covered by the ribbon. According to this shingled configuration, however, any such short finger portions of other singulated interior strips included as part of the string would be obscured by the overlapping edge of the upstream strip, thereby rendering such strips nearly visually indistinguishable from the other strips (including end strips) making up the string.

Given this visual appearance, both the end strips and the interior strips can be selected and positioned indiscriminately in assembling a module. This characteristic improves efficiency and ultimately reduces module cost.

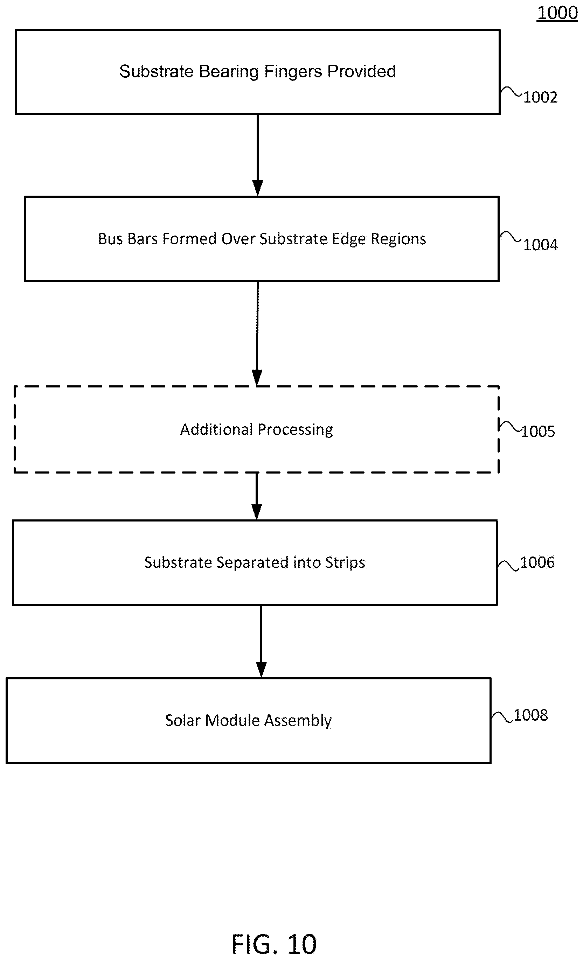

Figure 10 is a simplified diagram illustrating a generalized process flow 1000 according to an embodiment. At 1002, a semiconductor substrate bearing a plurality of thin electrically conductive fingers oriented in parallel along a first axis, is provided. On each end, the thin conductive fingers stop short a distance from an edge of the substrate.

At 1004, a plurality of front bus bars are formed in parallel along a second axis to overlap the thin electrically conductive fingers. Of these, two edge front bus bars overlap and cover the respective distances at each end of the substrate. Other front bus bar(s) are located in the interior region of the substrate surface, away from the ends, overlapping the continuous thin conductive fingers in an interior region of the substrate.

At 1005, additional structures may be formed on the substrate. For example, back side bus bars may be formed on the back side of the substrate. In particular, those back side bus bars may be formed specifically aligned with the expected location of the lines along which the individual strips will be separated.

At 1006, the substrate is separated along separation lines into individual strips having respective front side bus bars. In particular, a first end strip includes a first front bus bar covering a distance at the first edge of the substrate. A second end strip includes a second front bus bar covering a distance at the second edge of the substrate opposite from the first edge. A third end strip includes a third bus bar present in an interior region of the substrate.

At 1008, the first, second, and third strips are assembled into a solar module.

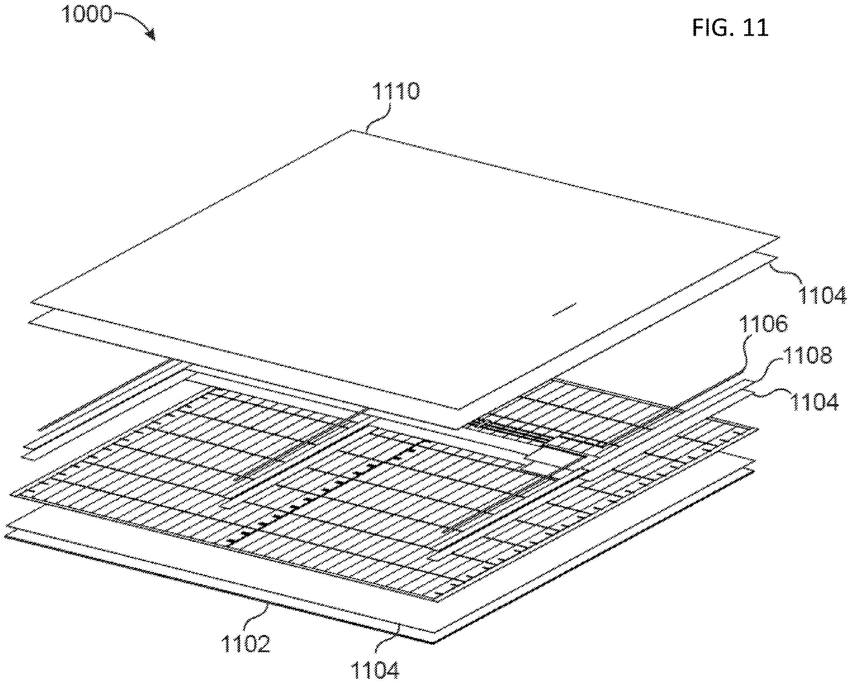

Assembly of a module from separated strips according to certain embodiments, is now discussed. FIG. 11 illustrates a back-facing view of components of an embodiment of a PV module 1100.

An outer surface of PV module 1100 is a glass panel 1102, and a translucent laminate material 1104 is disposed between the glass panel and the aperture side of PV elements. In an embodiment, the laminate material 1104 is a sheet of EVA film that encapsulates the PV elements when the PV module 1100 is assembled. When a PV module is assembled, heat, vacuum and pressure may be applied to components of the module shown in FIG. 11 so that the laminate material seals and bonds to adjacent components.

PV elements are disposed directly beneath the laminate 1104. In an embodiment of the present disclosure, the PV elements are a plurality of strings 300, each of which comprises a corresponding plurality of strips 302. Each of the strings 300 has a front ribbon 700 disposed on a first end of the string, and a back ribbon 800 disposed on an opposing second end of the string.

Bus wiring 1106 is disposed behind the plurality of strings 300. The bus wiring 1106 connects front and back terminals of the PV strings 300 to circuitry of the PV module. Although the present embodiment uses flat bus wiring 1106, other embodiments may use other wire shapes.

A plurality of insulation patches 1108 are disposed between the PV material and the flat bus wiring 1106 to prevent electrical shorts between conductive elements of the PV module 1100. A second translucent element 1004 is disposed behind the bus wiring 1106 and insulation patches 1108, followed by a backsheet 1110 which forms an outer backing surface of the PV module.

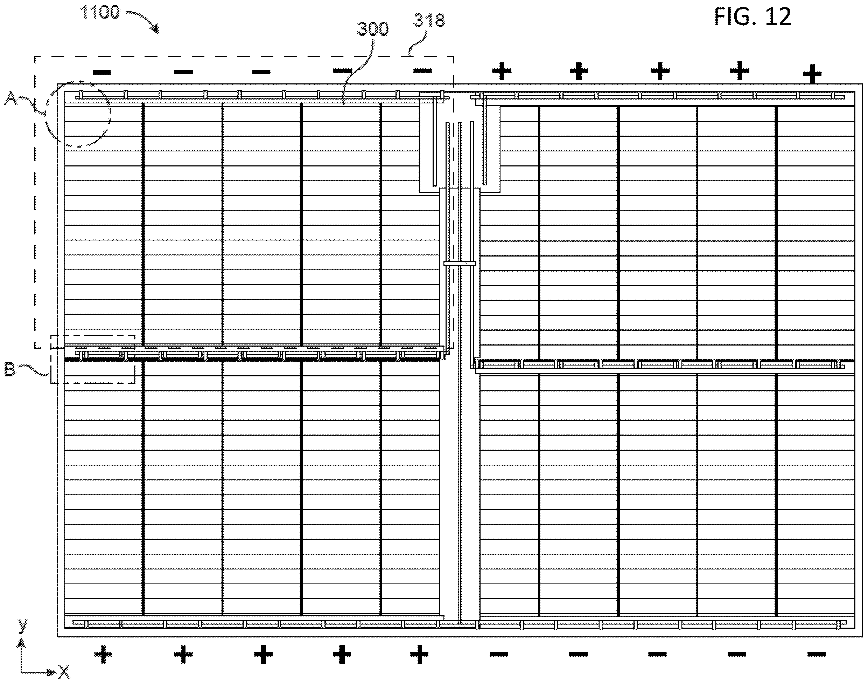

FIG. 12 illustrates a back view of a PV module 1100. As seen in the embodiment of FIG. 12, five PV strings 300 are arranged in parallel to one another to create four separate zones 318. Each of the PV strings 300 of each zone 318 have opposing terminal ends that are aligned with each other and commonly coupled to the same bus wire 1106. Zones are arranged so that a front terminal of one zone 318 is adjacent to a back terminal of an adjacent zone.

For example, the front terminal end of the zone in the lower left sector of FIG. 12 is directly adjacent to the back terminal end of the zone in the upper left sector, or the X direction as indicated in the figure. Similarly, the back and front terminal ends of each zone 318 are in an opposite orientation from the orientation of an adjacent zone in the Y direction. As a result, each terminal end of each zone 318 is adjacent to a terminal end of another zone with an opposite polarity.

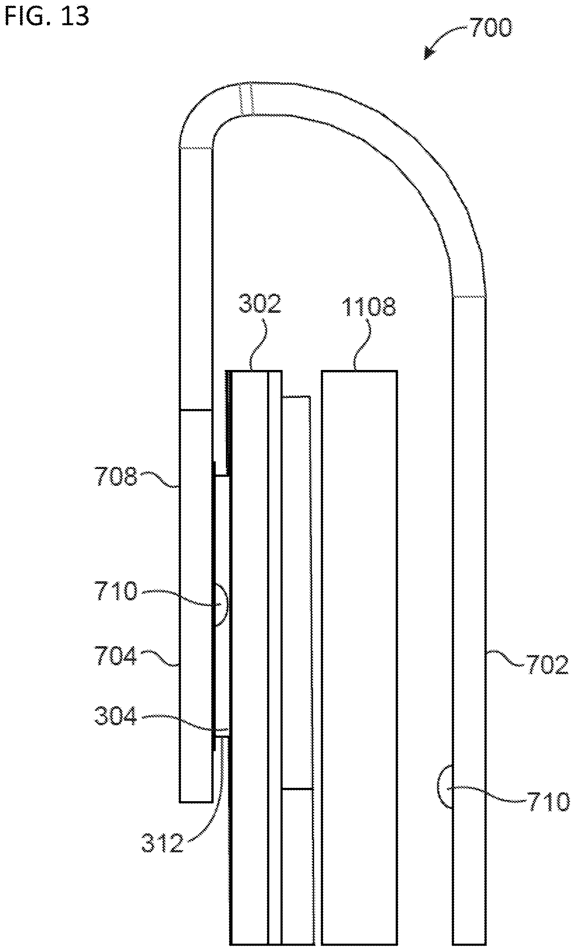

FIG. 13 is a detail view of section A of FIG. 12 and shows a front terminal end of a PV strip 302 of a PV string 300 according to an embodiment of the present disclosure. A bus interface portion 704 of front ribbon 700 is coupled to a front bus bar 304 through a layer of ECA 312. Tabs 702 of the front ribbon 700 extend past the edge of the PV strip 302 by a predetermined distance that may be 1.0 mm or less, or between 0.5mm and 2.0mm. The gap created by the predetermined distance may prevent damage to the PV material.

In an embodiment, a tool is used to form the bend the front ribbon 700 over the edge of the PV strip 302. The tool may ensure that the predetermined gap is provided while fixing the ribbon material in place so that the ECA bond is not compromised when the tabs are bent. The tabs may be bent 180 degrees from a flat orientation so that they extend in an opposite direction compared to a flat orientation of the ribbon 700.

An opaque coating material 708 is present on outward-facing portions of the front ribbon 700 that are visible when a PV module 1000 is assembled. The entire bus interface portion 704 of the front ribbon is coated with the opaque coating 708. In addition, portions of the tabs 702 are coated with coating 708 so that the coated portion of the tabs is contiguous with the coating over the bus interface 704. The portions of the tabs 702 that are coated are portions that that are folded over the edge of the PV strip 302. In an embodiment in which a coating material is present in those areas of the conductive ribbon 700, no reflective surfaces of the conductive ribbon are visible in an assembled PV module 1000.

An insulation patch 1108 is disposed between a backside surface of the PV strip 300 and an inner surface of front ribbon 700. The insulation patch 1108 may be secured to the backside surface of the PV strip 302 by an adhesive or laminate material such as EVA. In the embodiment shown in FIG. 12, conductive protrusions 710 that extend from a surface of the bus interface 704 are aligned with the front bus bar 304 of the PV strip 302, and provide a low resistance connection between the front ribbon 700 and the PV strip. In contrast, the conductive protrusions 710 on tabs 702 face inwards towards insulation patch 1008. Accordingly, in the embodiments shown in FIG. 12, the conductive protrusions 710 on the tabs 704 are not in a conductive path between the ribbon 700 and a bus of a PV strip 302.

One of the advantages that conductive ribbons provide over conventional solar modules is reducing current density. Embodiments of the bus interface parts 704 and 804 cover the entire surface of the font busses, and ECA is present in most or all of the space between the bus interface parts and the busses. Accordingly, the current density of such embodiments is much lower than the current density of conventional modules, in which the area of the conductive interface is limited to solder connections to which wires are connected.

Returning to FIG. 12, the tabs 702 of front ribbons 700 disposed on outer edges of the PV strings 300 on a top edge of the module are connected to a first flat bus wire 1106. Similarly, tabs 802 of back ribbons 800 along the top edge are coupled to a second bus wire 1106. In contrast, the tabs 702 and 802 of respective front and back ribbons 700 and 800 that are disposed along bottom edge of the module 1100 are commonly coupled to the same bus wire 1106. Similarly, front ribbons 700 and back ribbons 800 of adjacent edges of adjacent zones 318 are commonly coupled to the same bus wire 1106.

The connection between tabs of the front and back ribbons and the bus wiring 1006 may be a solder connection or an ECA connection. When an ECA connection is present, conductive protrusions disposed on the tabs may be aligned with the ECA material. In some embodiments, the conductive protrusions on tabs of a conductive ribbon may be present on an opposite face of the ribbon from the conductive protrusions on the bus interface part of the same ribbon. In other words, conductive protrusions on a ribbon's tabs may be on the opposite face from the conductive ribbons on the ribbon's bus interface.

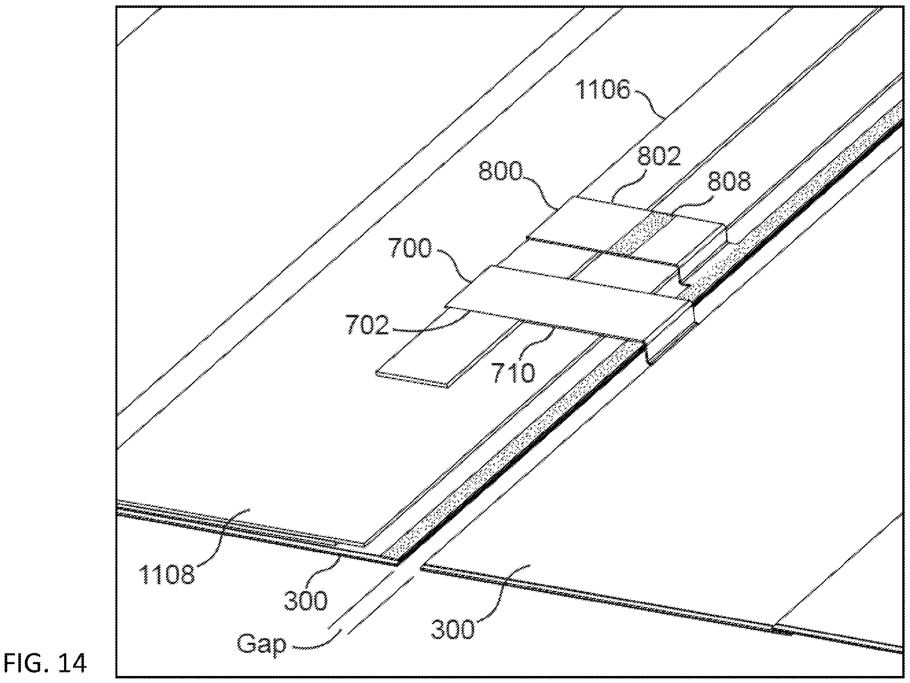

FIG. 14 is a detail view of section B of FIG. 12, and shows ribbon configurations for adjacent PV strings 300. A bus interface 804 of the back ribbon 800 is coupled to the back bus bar 306 of an edge strip 302 so that the coated surface of the back ribbon faces outwards from the back face of the PV material. In an embodiment, an insulation patch 1108 is coupled to the back surface of the PV material, and may be retained by an adhesive or laminate material such as EVA.

Tabs 802 of back ribbon 800 extend away from bus interface 804, fold over the insulation patch 1108, and are coupled to the bus wiring 1106. Tabs 702 of the front ribbon 700 fold over from the front of the strip to which they are attached to the back surface of the strip 302 to which the back ribbon 800 is attached.

Accordingly, the tabs 802 of the back ribbon 800 attached to a first string 300 are aligned in parallel with the tabs 702 of the front ribbon 700 of a second string 300 that is adjacent to the first strip. Therefore, in an embodiment in which opposing terminals of PV strings 300 are adjacent to one another, tabs of respective conductive ribbons are routed in the same direction and are commonly coupled to the same bus wire 1106.

Returning to FIG. 12, the efficient and unique arrangement of components in a PV module 1100 provides a number of technological advantages. Use of the same bus material 1106 to connect tabs of conductive ribbons from opposite poles of adjacent zones 318 achieves simultaneous series connections between separate zones and parallel connections between strings 300 within the same zone, as seen in FIG. 5, while minimizing the number of connections and the amount of materials in a panel. Therefore, a PV module 1100 according to an embodiment of the present application is highly efficient and reliable.

In addition, elements of the panel arrangement of the panel 1100 provide a PV panel that does not have reflective surfaces that are visible from the aperture side of the panel. Tiling of PV strips in each of the strings hides metallic bus bars that are visible in conventional panels. Although a PV strip 302 at each end of a PV string 300 has one bus region for which a metallic bus bar would be exposed, embodiments of the present application completely cover that bus bar with a conductive ribbon, and all surfaces of the conductive ribbon that are visible in an assembled PV module are covered with an opaque coating material. Meanwhile, the PV strings are arranged in the panel so that no gaps greater than a few millimeters are present between adjacent strips and strings, and what gaps are present are minimal in size. Components of the PV module may be attached to form a mechanical sub-structure that retains components in place during a lamination process to ensure that gaps and alignment are maintained to a high tolerance.

Apart from the coated surfaces of the conductive ribbons, no bus wiring is visible from an aperture side of a PV module 1100. The only reflective elements than can be perceived from the aperture side of a PV module 1100 according to an embodiment of the present disclosure are the fingers that run across the surface of PV material, and the fingers are too small to be noticeable from a distance of 10 feet or more, so that fingers are not perceived as reflective surfaces from most viewing positions of a typical PV installation.

In some embodiments, solar modules may use PV strips that do not have busses that comprise conductive material on the solar cells, or "busbarless" cells. For example, embodiment may use strips that are cut from cells such as the cells shown in design patent applications 29/646,603 and 29/646,604, each of which is incorporated by reference herein. In such embodiments, conductive ribbons may be coupled to areas that correspond to the areas in which conductive bus material is normally applied, which may be referred to as bus regions. The conductive interface between conductive ribbons and a bus region of a busbarless strip may be an ECA material that interfaces with the conductive fingers that are oriented orthogonal to the ribbon junctions. A busbarless cell has numerous advantages over a cell with printed busbars, including lower cost and a superior electrical connection between the fingers and adjacent cells that are overlapped and coupled with ECA.

While the above is a full description of the specific embodiments, various modifications, alternative constructions and equivalents may be used. Although the above has been described using a selected sequence of steps, any combination of any elements of steps described as well as others may be used. Additionally, certain steps may be combined and/or eliminated depending upon the embodiment.

Of course there can be other variations, modifications, and alternatives. Therefore, the above description and illustrations should not be taken as limiting the scope of the present invention which is defined by the appended claims.

## Claims

1. A solar module comprising:
a first strip (104, 106) of photovoltaic material including,
a front surface including a first plurality of parallel thin electrically conductive fingers (114),
µ-chamfers (170) located at corners of a first strip edge of the first strip;
a first bus bar (102) overlapping the first plurality of thin electrically conductive fingers and inset from the first strip edge by a gap (105), ends of the first bus bar not overlapping the µ-chamfers; and
a second strip (108) of photovoltaic material arranged in series with the first strip and including,
a front surface including a second plurality of parallel thin electrically conductive fingers, corners of a second strip edge of the second strip forming a right angle,
a second bus bar on the front surface inset from the second strip edge by a second gap including the second plurality of conductive fingers, the second bus bar overlapping the second plurality of thin electrically conductive fingers, wherein the second strip edge of the second strip overlaps the first gap, the µ-chamfers, and the first bus bar in a shingled configuration, wherein ends (299) of the first bus bar are tapered, and
wherein the first plurality of parallel thin electrically conductive fingers stop short of the first strip edge of the first strip by a distance, and extend all the way to a second strip edge of the first strip opposite to the first strip edge of the first strip.

2. A solar module as in claim 1 wherein the µ-chamfers comprise a circular arc segment defined by a radius.

3. A solar module as in claim 1 wherein the µ-chamfers comprise a linear segment.

4. A solar module as in claim 1 wherein the second strip edge of the second strip has a length of about 157 mm.

5. A solar module as in claim 1 wherein the distance comprises about 0.5mm.

6. A solar module as in claim 4 wherein the second strip has a width of 31.3 mm.

7. A solar module as in claim 4 wherein the second strip has a width of 26 mm.

## Patentansprüche

1. Solarmodul, umfassend:
einen ersten Streifen (104, 106) aus einem photovoltaischen Material, umfassend
eine vordere Oberfläche, die eine erste Vielzahl von parallelen dünnen elektrisch leitfähigen Fingern (114) umfasst,
Mikrofasen (170), die sich an Ecken eines ersten Streifenrands des ersten Streifens befinden;
eine erste Sammelschiene (102), die die erste Vielzahl von dünnen elektrisch leitfähigen Fingern überlappt und von dem ersten Streifenrand her durch einen Spalt (105) eingefügt ist, wobei die Enden der ersten Sammelschiene die Mikrofasen nicht überlappen; und
einen zweiten Streifen (108) aus photovoltaischem Material, angeordnet in Reihe mit dem ersten Streifen und umfassend
eine vordere Oberfläche, die eine zweite Vielzahl von parallelen dünnen elektrisch leitfähigen Fingern umfasst, wobei Ecken eines zweiten Streifenrands des zweiten Streifens einen rechten Winkel bilden,
eine zweite Sammelschiene auf der vorderen Oberfläche, die von dem zweiten Streifenrand her durch einen zweiten Spalt eingefügt ist, umfassend die zweite Vielzahl von leitfähigen Fingern, wobei die zweite Sammelschiene die zweite Vielzahl von dünnen elektrisch leitfähigen Fingern überlappt,
wobei der zweite Streifenrand des zweiten Streifens den ersten Spalt, die Mikrofasen und die erste Sammelschiene in einer Schindelkonfiguration überlappt, wobei Enden (299) der ersten Sammelschiene verjüngt sind, und
wobei die erste Vielzahl von parallelen dünnen elektrisch leitfähigen Fingern um einen Abstand kurz vor dem ersten Streifenrand des ersten Streifens enden und sich über die ganze Strecke bis zu einem zweiten Streifenrand des ersten Streifens erstrecken, der dem ersten Streifenrand des ersten Streifens gegenüberliegt.

2. Solarmodul nach Anspruch 1, wobei die Mikrofasen ein Kreisbogensegment umfassen, das durch einen Radius definiert wird.

3. Solarmodul nach Anspruch 1, wobei die Mikrofasen ein geradliniges Segment umfassen.

4. Solarmodul nach Anspruch 1, wobei der zweite Streifenrand des zweiten Streifens eine Länge von ungefähr 157 mm aufweist.

5. Solarmodul nach Anspruch 1, wobei der Abstand ungefähr 0,5mm beträgt.

6. Solarmodul nach Anspruch 4, wobei der zweite Streifen eine Breite von 31,3 mm aufweist.

7. Solarmodul nach Anspruch 4, wobei der zweite Streifen eine Breite von 26 mm aufweist.

## Revendications

1. Module solaire, comprenant :
une première bande (104, 106) de matériau photovoltaïque comprenant,
une surface avant comprenant une première pluralité de doigts minces parallèles conducteurs d'électricité (114),
des micro-chanfreins (170) situés au niveau de coins d'un premier bord de bande de la première bande ;
une première barre omnibus (102) chevauchant la première pluralité de doigts minces conducteurs d'électricité et décalée vers l'intérieur par rapport au premier bord de bande par un espace (105), des extrémités de la première barre omnibus ne chevauchant pas les micro-chanfreins ; et
une seconde bande (108) de matériau photovoltaïque agencée en série avec la première bande et comprenant,
une surface avant comprenant une seconde pluralité de doigts minces parallèles conducteurs d'électricité, des coins d'un second bord de bande de la seconde bande formant un angle droit,
une seconde barre omnibus sur la surface avant décalée vers l'intérieur par rapport au second bord de bande par un second espace comprenant la seconde pluralité de doigts conducteurs, la seconde barre omnibus chevauchant la seconde pluralité de doigts minces conducteurs d'électricité,
dans lequel le second bord de bande de la seconde bande chevauche le premier espace, les micro-chanfreins et la première barre omnibus selon une configuration en bardeaux, dans lequel des extrémités (299) de la première barre omnibus sont tronconiques, et
dans lequel la première pluralité de doigts minces parallèles conducteurs d'électricité s'arrêtent avant le premier bord de bande de la première bande, à une distance, et s'étendent jusqu'à un second bord de bande de la première bande opposé au premier bord de bande de la première bande.

2. Module solaire selon la revendication 1, dans lequel les micro-chanfreins comprennent un segment d'arc circulaire défini par un rayon.

3. Module solaire selon la revendication 1, dans lequel les micro-chanfreins comprennent un segment linéaire.

4. Module solaire selon la revendication 1, dans lequel le second bord de bande de la seconde bande a une longueur d'environ 157 mm.

5. Module solaire selon la revendication 1, dans lequel la distance comprend environ 0,5 mm.

6. Module solaire selon la revendication 4, dans lequel la seconde bande a une largeur de 31,3 mm.

7. Module solaire selon la revendication 4, dans lequel la seconde bande a une largeur de 26 mm.
